# EUROPEAN PATENT SPECIFICATION

(11) **EP 4 099 327 B1**
(45) Date of publication and mention of the grant of the patent: **21.10.2026**
(21) Application number: 21177707.3
(22) Date of filing: 04.06.2021
(51) Int. Cl.: G11C 13/00

(54) **METHOD FOR PROGRAMMING AN ARRAY OF RESISTIVE MEMORY CELLS**
VERFAHREN ZUM PROGRAMMIEREN EINES ARRAYS VON RESISTIVEN SPEICHERZELLEN
PROCÉDÉ DE PROGRAMMATION D'UN RÉSEAU DE CELLULES DE MÉMOIRE RÉSISTIVE

(43) Date of publication of application: 07.12.2022
(73) Proprietor: Commissariat à l'Energie Atomique et aux Energies Alternatives, 75015 Paris (FR); Weebit Nano Ltd, 4527713 Hod-HaSharon (IL)
(72) Inventor: MOLAS, Gabriel, 38054 GRENOBLE CEDEX 09 (FR); BRICALLI, Alessandro, 38000 GRENOBLE (FR); PICCOLBONI, Guiseppe, 37124 VERONA (IT); REGEV, Amir, MODIN (IL)
(74) Representative: Cabinet Camus Lebkiri

(56) References cited:
- WO-A1-2015/065415
- WO-A1-2018/136187
- US-A1- 2014 226 388
- HAYAKAWA ATSUNA ET AL: "Resolving Endurance and Program Time Trade-Off of 40nm TaOx-Based ReRAM by Co-Optimizing Verify Cycles, Reset Voltage and ECC Strength", 2017 IEEE INTERNATIONAL MEMORY WORKSHOP (IMW), IEEE, 14 May 2017 (2017-05-14), pages 1 - 4, XP033104990, DOI: 10.1109/IMW.2017.7939101

## Description

### TECHNICAL FIELD

The present invention belongs to the technical field of the Resistive Random-Access Memories (ReRAM) comprising an array of resistive memory cells. An object of the invention is a method for programming at least a part of an array of resistive memory cells in an efficient manner.

### STATE OF THE ART

A Resistive Random-Access Memory (ReRAM) is a type of rewritable non-volatile memory. It comprises an array of resistive memory cells, each cell comprising a resistive memory element and a selection transistor connected in series with the resistive memory element. The resistive memory element comprises a first electrode and a second electrode separated by a dielectric material layer. The application of an electric potential difference to the two electrodes leads to the formation or the removal of an electrical connection between the two electrodes.

After the electrical connection is formed, the resistive memory cell is in a low resistance state (LRS). This first state is also called ON state or conducting state. When the electrical connection is removed, the resistive memory cell is in a high resistance state (HRS). This second state is also called OFF state or insulating state. The electrical resistance associated to the LRS is called R_{LRS}, while the electric resistance associated to the HRS is called R_{HRS}.

The existence of these two ON/OFF states makes it possible to use the resistive memory cell as a rewritable non-volatile memory by encoding one bit of information. A memory cell may also be called a memory point.

Several mechanisms may be responsible for the formation of the electrical connection between the two electrodes (see for example the article "Resistive Memories for Ultra-Low-Power Embedded Computing Design" published by E. Vianello et al. in Electron Devices Meeting 2014 IEEE International). For example, in the case of memory cells known as OxRAM (Oxide-based RAM), a conductive filament is formed by oxygen vacancies in the dielectric material layer (here an oxide layer) separating the two electrodes. Alternatively, in resistive random-access memories known as CBRAM (Conductive-Bridging RAM), one of the two electrodes dissolves in the dielectric material and supplies the ions forming the conductive filament. In ReRAM known as PCRAM (Phase-Change RAM), the two electrodes are separated by a programmable region comprising a phase-change material (PCM). This material is able to change from crystalline phase to amorphous phase upon heating. In this type of ReRAM, the OFF state corresponds to the amorphous phase, while the ON state corresponds to the crystalline phase of the programmable region. PCRAM cells may also comprise a heater element inserted between the two electrodes and able to transform the applied voltage pulse in the heat necessary to modify the phase of the programmable region.

During their utilization, arrays of resistive memory or ReRAM cells undergo a great number of set and reset operations. A set operation comprises placing the cell in the LRS and a reset operation comprises placing the cell in the HRS. The application of a set followed by a reset application or vice versa is called a cycle. Both set and reset operations can be performed by applying voltage pulses having opposite polarities.

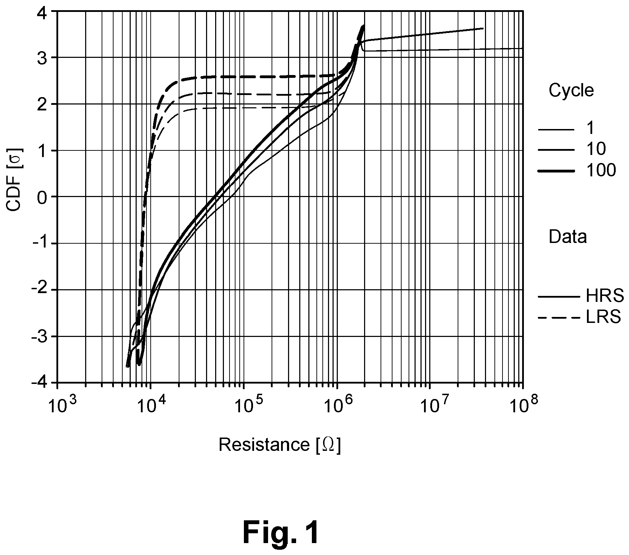

Arrays of resistive memory cells suffer from variability in the resistance values associated to the HRS and the LRS. Figure 1 represents (according to a standard deviation scale) the cumulative distribution function (CDF) of the measured electric resistances for the HRS and the LRS in a ReRAM array after different numbers of cycles. For both states, it is apparent that memory cells can have many different resistance values. The dispersion of the HRS and LRS leads to difficulties in distinguishing the two memory states. In other words, resistive memory arrays in which the HRS and LRS are not clearly distinguished may lead to errors in reading the array and thus to resistive memory arrays that are not reliable.

Even if the variability of the R_{HRS} values is higher than the variability of the R_{LRS} values, some efforts must be made to narrow the distribution of resistance values in the LRS.

One of the most used techniques to reduce the variability in the LRS is the full reprogramming of the cell. The full reprogramming technique comprises a reset operation followed by a new set operation. However, some cells may have a particular behavior and need to be treated differently, because the physical mechanism of their filament formation is inherently different. In that case, full reprogramming is not the most effective technique to correctly place a resistive memory cell in the LRS.

Other programming techniques have been proposed to stress more the cell during the set operation, for instance by increasing the voltage pulse duration or amplitude. Further programming methods are described in prior art non patent literature publication "Resolving Endurance and Program Time Trade-Off of 40nm TaOx-Based ReRAM by Co-Optimizing Verify Cycles, Reset Voltage and ECC Strength", by Hayakawa Atsuna et al., 2017, IEEE International Memory Workshop (IMW), pages 1-4, XP033104990 and patent application publications WO 2015/065415 A1, US 2014/226388 A1 and WO 2018/136187 A1.

Nevertheless, the person skilled in the art does not know which one of these set techniques to use (and when) to obtain a reliable method for programming an array of resistive memory cells.

### SUMMARY OF THE INVENTION

There is therefore a need to provide a reliable method for programming an array of resistive memory cells.

According to an aspect of the invention, this need is satisfied by providing a method for programming at least one resistive memory cell of an array of resistive memory according to claim 1.

The programming method establishes an order for the application of the available set techniques, said order being based on a figure of merit of the memory array, and more particularly on the bit error ratio (BER). Thanks to this method, it is possible to apply an adapted sequence of set techniques in order to reduce the dispersion of the low resistance state (LRS). Indeed, the application of different reset techniques makes it possible to deal with the memory cells of the array having a non-ideal behavior and to reduce the bit-to-bit variability.

The plurality of set techniques are preferably algorithms comprising set operations and reset operations and read and verify operations.

In an embodiment, the bit error ratio (BER) value corresponding to each programming cycle for each set technique is measured prior to the programming cycles by characterizing a reference array of resistive memory cells and a sequence of the set techniques to be applied during the programming cycles is then defined.

In an alternative embodiment, the bit error ratio (BER) value corresponding to each programming cycle for each set technique is acquired from a database.

According to a development of this alternative embodiment, the bit error ratio (BER) value corresponding to each programming cycle for each set technique is measured prior to the programming cycles by characterizing a reference array of resistive memory cells and then stored in the database.

A second aspect of the invention relates to an electronic circuit according to independent claim 6.

Only embodiments comprising all the features of independent claim 1 or of independent claim 6 fall under the scope of protection of the present invention.

### BRIEF DESCRIPTION OF THE FIGURES

Other characteristics and advantages of the invention will become clear from the description that is given thereof below, by way of indication and in no way limiting, with reference to the appended figures, among which:
- figure 1 represents the distribution of the resistance values for an array of resistive memory cells at different programming cycles;
- figure 2 is a flowchart of a method for programming at least one resistive memory cell, according to an aspect of the invention;
- figure 3 schematically represents a resistive memory cell switching between a high resistance state (HRS) and a low resistance state (LRS);
- figure 4 is a timing diagram of a set technique comprising the application of voltage pulses of increasing amplitude;
- figure 5 is an abacus representing the bit error ratio of a reference array as a function of the number of programming cycles of the reference array, for various set techniques used during the set step of the programming cycles;
- figure 6 represents, as a function of the number of programming cycles of the reference array, the capability of correcting the hard fails for the same set techniques;
- figure 7 represents the distribution of the LRS resistance values of the reference array, after hundred programming cycles and for the same set techniques used during the set step of the programming cycles.

For greater clarity, identical or similar elements are marked by identical reference signs in all of the figures.

### DETAILED DESCRIPTION OF AT LEAST ONE EMBODIMENT

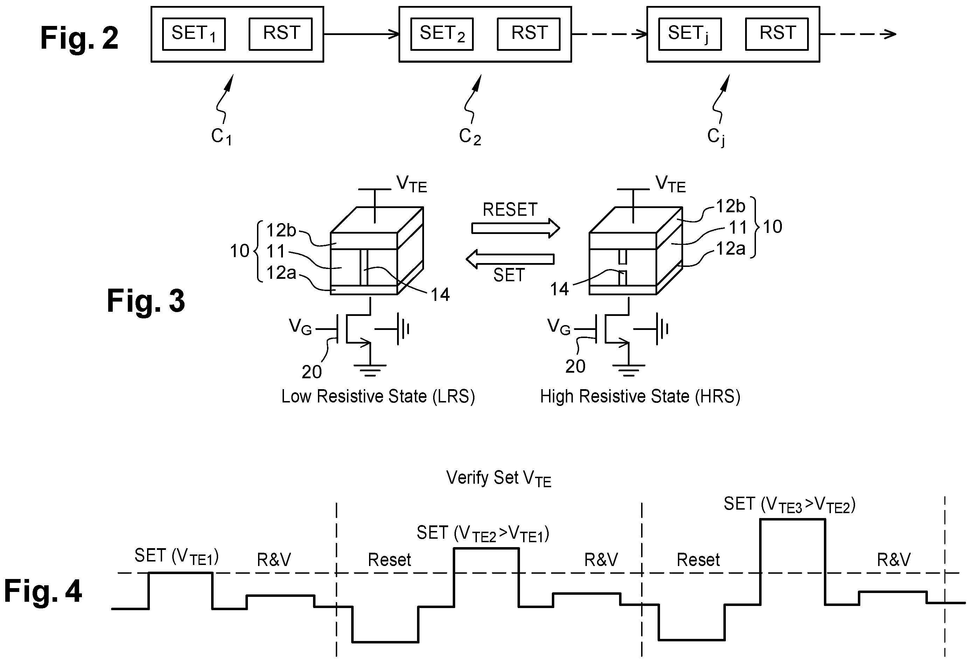

Figure 2 schematically represents a method 200 for programming an array of resistive memory cells. An array of resistive memory cells comprises a plurality of resistive memory cells arranged in lines and in columns.

As shown on figure 3, each resistive memory cell of the array comprises a resistive memory element 10 and a selection transistor 20 connected in series with the resistive memory element 10.

The resistive memory element 10 can switch in a reversible manner between a high resistance state called "HRS" (or OFF state) and a low resistance state called "LRS" (or ON state). These two resistance states make it possible to store an information bit in each memory cell.

The resistive memory element 10 comprises a dielectric material layer 11 arranged between two electrodes:
- a first electrode 12a referred to as "bottom electrode", on which is arranged the dielectric material layer 11; and
- a second electrode 12b referred to as "top electrode" and arranged on the dielectric material layer 11.

The dielectric material layer 11 may also be called "resistive material layer" (since the dielectric material has a variable electrical resistance).

The resistive memory element 10 is preferably a filament-type memory element, that is a memory element wherein the change of resistance state is governed by the formation and the removal of a conductive filament 14 between the two electrodes 12a-12b.

The resistive memory element 10 may be an OxRAM (Oxide-based Random Access Memory) element. The resistive material is then an oxide, for example a transition metal oxide (e.g. HfO₂, Ta₂O₅, TiO₂...) or a silicon oxide (SiOₓ, with x comprised between 1 and 2). The electrodes 12a-12b are electrically conductive layers and may be formed from one or more conductive materials such as titanium, titanium nitride, doped silicon, tungsten, tungsten nitride, metal silicides and platinum.

Alternatively, the resistive memory element 10 may be a CBRAM (Conductive-Bridging Random Access Memory) element. The resistive material is then an ionic conductive and electrically insulating material. One of the electrodes (the cathode) is made of an inert material and the other electrode (the anode) is made of a soluble material.

The resistive memory element 10 may also be a PCRAM (Phase-Change Random Access Memory) or a FeRAM (Ferroelectric Random Access Memory) element.

The memory cells of the array may be subjected, individually or collectively, to programming operations. The programming operations consist in switching the resistive memory element 10 between the high resistive state (HRS) and the low resistive state (LRS). When the resistive memory element 10 changes from the HRS to the LRS, the corresponding programming operation is referred to as a writing or set operation. Conversely, when the resistive memory element 10 changes from the LRS to the HRS, the corresponding programming operation is referred to as an erasing or reset operation. A programming operation can therefore be either a set operation or a reset operation.

The resistive memory element 10 is placed in the HRS when its electrical resistance value is higher than a first resistance threshold R_{TH_HRS} and in the LRS when its electrical resistance value is lower than a second resistance threshold R_{TH_LRS}. The second resistance threshold R_{TH_LRS} is lower than or equal to the first resistance threshold R_{TH_HRS}. The ratio between the first and second resistance thresholds is called the "programming window" (PW) of the memory cell: $PW = \frac{{R}_{TH _ HRS}}{{R}_{TH _ LRS}}$

It is preferable that the second resistance threshold R_{TH_LRS} is strictly lower than the first resistance threshold R_{TH_HRS} (in other words, one resistance threshold per state) in order to have well separated resistance states (for improved reliability).

A memory cell of the array may also be subjected to reading operations. A reading operation consists in measuring the electrical resistance of the resistive memory element 10 in order to determine its resistance state.

The selection transistor 20 serves to bias the resistive memory element 10 so as to program or read the memory cell, and also acts as a current limiter during the set operation so as not to degrade the resistive memory element 10. The drain of the selection transistor 20 is connected to the bottom electrode 12a of the resistive memory element 10.

To perform a set, a reset or a read operation, a first voltage V_{TE} is applied to the top electrode 12b of the resistive memory element 10, a second voltage V_{G} is applied to the gate of the selection transistor 20 and a third voltage Vs is applied to the source of the selection transistor 20. Values of the top electrode voltage V_{TE}, of the gate voltage V_{G} and of the source voltage V_{S} depend on the operation to be performed and on the resistive memory technology (type of the resistive memory element, materials and thicknesses of the dielectric layer and of the electrodes).

With reference to figure 2, the programming method 200 comprises applying a sequence of N programming cycle Cⱼ to one or more memory cells of the array, N being an integer greater than or equal to 2. An index j, ranging from 1 to **N,** is used to number the programming cycles of the sequence.

Each programming cycle comprises a step SETⱼ of setting the memory cell(s) and a step RST of resetting the memory cell(s). The reset steps RST of the sequence may be a conventional reset operation, i.e. the application of one negative voltage pulse between the electrodes 12a-12b of the resistive memory element 10 (V_{TE} - Vs < 0). The set steps SETⱼ of the sequence are not performed by simply applying one positive voltage pulse between the electrodes 12a-12b. Each set step SETⱼ of the sequence comprises the application of a particular set technique. The set steps SETⱼ are thus optimized set operation.

The set technique applied at the set step SETj of each programming cycle Cⱼ is chosen among a plurality of set techniques. The plurality of set techniques comprises:
- Full reprogramming;
- Verify Set V_{TE}: applying voltage pulses with increasing amplitudes on the top electrode 12b of the resistive memory element 10 (the gate voltage V_{G} and the source voltage Vs being the same at each pulse); and
- Verify Set V_{G}: applying voltage pulses with increasing amplitudes on the gate of the selection transistor 20 (the top electrode voltage V_{TE} and the source voltage Vs being the same at each pulse), which is equivalent to increasing the compliance current of the memory cell.

These set techniques are preferably algorithms comprising set operations, reset operations and read and verify (R&V) operations (such algorithms are referred to as R&V algorithms).

The full reprogramming set technique comprises applying one or more reprogramming cycles, each reprogramming cycle comprising a reset operation followed by a set operation and a R&V operation. During a R&V operation, the electrical resistance of the cell is measured and compared to the second resistance threshold R_{TH_LRS}. If the electrical resistance of the cell is lower than the second resistance threshold R_{TH_LRS}, the ongoing reprogramming cycle has succeeded, and the algorithm is ended. If the electrical resistance of the cell is higher than the second resistance threshold R_{TH_LRS}, the ongoing reprogramming cycle has failed, and a new reprogramming cycle is performed. The algorithm continues so on until a maximum number of reprogramming cycles is reached (for example 5 reprogramming cycles).

Identical reset conditions are applied during the different reset operations of the reprogramming cycles and identical set conditions are applied during the different set operations of the reprogramming cycles. The set and reset conditions are the amplitude and the duration of the voltage pulses applied between the electrodes 12a-12b of the resistive memory element 10 and to the gate of the selection transistor 20. These set and reset conditions are preferably standard. For example, for an OxRAM element 10 comprising a bottom electrode 12a made of TiN, a dielectric material layer 11 made of SiOₓ and a top electrode 12b made of Ti, the top electrode voltage V_{TE} may be 0 V during each reset operation and 2.8 V during each set operation, the gate voltage V_{G} may be 4.5 V during each reset operation and 2.5 V during each set operation, the source voltage Vs may be 1.8 V during each reset operation and 0 V during each set operation. The duration of the voltage pulses applied between the electrodes and to the gate of the selection transistor 20 is 1 µs during the reset operations and 100 ns during the set operations.

Figure 4 is a diagram showing a preferred embodiment of the second set technique "Verify Set V_{TE}" (R&V algorithm increasing the top electrode voltage V_{TE}). This second R&V algorithm comprises a first set operation, wherein a first top electrode voltage V_{TE1} is applied to the memory cell(s) to be programmed, and a first R&V operation after the first set operation. If the electrical resistance of the cell is lower than the second resistance threshold R_{TH_LRS}, the first set operation has succeeded, and the algorithm is ended. If the electrical resistance of the cell is higher than the second resistance threshold R_{TH_LRS}, the first set operation has failed, and a reset operation and a new set operation are successively performed. A higher top electrode voltage V_{TE2} (V_{TE2} > V_{TE1}) is applied during the new set operation. Then, a new R&V operation is performed. The algorithm continues so on until a maximum top electrode voltage is reached or until a maximum number of set operations is performed.

In other words, the second set technique "Verify Set V_{TE}" comprises a first set operation, a first R&V operation and at least one sequence of the reset, set and R&V operations.

The top electrode voltage V_{TE} (during the set operations) is preferably increased by steps, according to a staircase. The top electrode voltage V_{TE} starts at a first nominal value and is increased by a first step voltage until it reaches a first end value. The first nominal value (or start value of the V_{TE} staircase) may be comprised between 2.5 V and 2.9 V, the first end value (end value of the V_{TE} staircase) may be comprised between 3.2 V and 3.5 V and the first step voltage may be comprised between 0.05 mV and 0.2 V.

The third set technique "Verify Set V_{G}" may also be, in a preferred embodiment, an algorithm comprising a first set operation, a first R&V operation and at least one sequence of the reset, set and R&V operations. This third algorithm is thus the same as shown on figure 4, except that the voltage to be increased during the set operations is the gate voltage V_{G}.

The gate voltage V_{G} is preferably increased by steps, according to a staircase. The gate voltage V_{G} starts at a second nominal value and is increased by a second step voltage until it reaches a second end value. The second nominal value (or start value of the V_{G} staircase) may be comprised between 2.0 V and 2.5 V, the second end value (or end value of the V_{G} staircase) may be comprised between 2.9 V and 3.2 V and the second step voltage may be comprised between 100 mV and 200 mV.

The maximum number of set operations in the second and third R&V algorithms may be comprised between 5 and 10.

The voltage pulse duration during the different set operations of the R&V algorithms is preferably constant, for example equal to 100 ns. The voltage pulse amplitude and the voltage pulse duration during the different reset operations of the algorithms are also preferably constant, for example respectively equal to 4.5 V and 1 µs.

When the set techniques described above are applied to several memory cells (for example a block of the array to be programmed), most of the cells will receive just one set pulse, because their electrical resistance is good after the first pulse they receive. Only a few cells with receive more than one set pulse (and one or more reset pulses).

The set technique to be used at each programming cycle Cⱼ is selected based on bit error ratio (BER) values corresponding to said programming cycle Cⱼ. The bit error ratio (BER) is the arithmetic mean of the number of memory cells not actually being placed in the LRS after a set operation and the number of memory cells not actually being placed in the HRS after a reset operation following or preceding the set operation.

A bit error ratio value corresponding to said programming cycle Cⱼ is thus acquired for each of the set techniques.

In an embodiment, the BER values may be acquired from a database by a controller coupled to the array of resistive memory cells. They are then compared and the set technique having the lowest BER value corresponding to said programming cycle Cⱼ is applied.

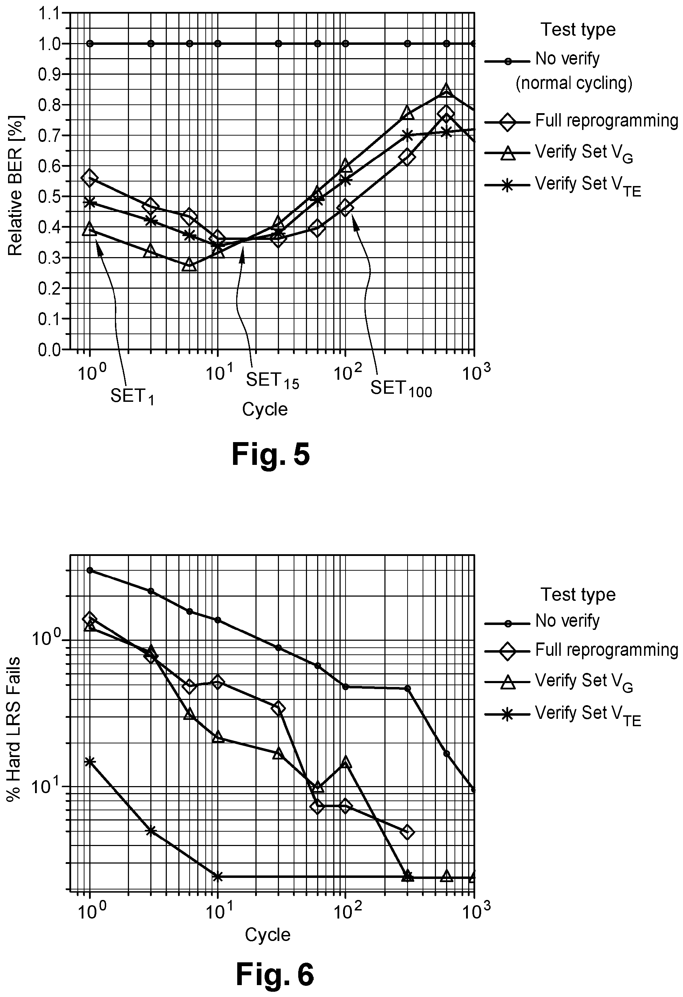

Figure 5 shows an example of BER values that may be stored in the database. This figure represents, as a function of the number of programming cycles, the relative BER of the three set techniques described previously. The relative BER of a given set technique is the BER of said technique normalized with respect to the BER obtained when a normal cycling of the cell is performed (standard set and reset operations, no optimized set operation). Thus, it can be seen the benefits in terms of error correction of the three set techniques with respect to a normal cycling.

In this example, the third set technique "Verify Set V_{G}" (increasing the gate voltage V_{G}) has the lowest (relative) BER values in the first cycles. It is then chosen as the set technique to be applied during the first programming cycles Cⱼ of the array (see for example SET₁ on figure 5). Then, after approximatively ten cycles, the second set technique "Verify Set V_{TE}" (increasing the top electrode voltage V_{TE}) become more effective. It is then chosen as the set technique to be applied during the following programming cycles Cj (see for example SET₁₅). Then, between (approximatively) the 20^{th} cycle and the 400^{th} cycle, the full reprogramming technique has the lowest BER value and is selected (see for example SET₁₀₀).

The different BER values for the different set techniques and at each programming cycle are preferably measured during a preliminary characterizing step (prior to the programming cycles) and then stored in the database. A reference array of resistive memory cells (of the same resistive memory technology than the array to be programmed) is subjected to a high number of programming cycles (for example more than 10⁴), each programming cycles comprising a reset step and a set step according to the considered set technique, as indicated above. The BER is calculated at each programming cycle, by measuring and averaging the number of LRS fails (i.e. the number of memory cells of the reference array not actually being placed in the LRS after the set step) and the HRS fails (the number of memory cells not actually being placed in the HRS after the reset step).

In another embodiment, the different BER values for the different set techniques and at each programming cycle are measured prior to the programming cycles during the characterizing step, then the sequence of the set techniques to be applied during the programming cycles is defined (based on the lowest BER values). The sequence may be stored in the controller (coupled to the array of resistive memory cells) or in a database in communication with the controller.

Figure 6 show the percentage of the memory cells of the reference array in a hard fail situation, as a function of the number of programming cycles. It is considered that a memory cell of the reference array is in a hard fail situation when its LRS resistance value (i.e. the electrical resistance after a set step) exceeds a threshold (much) higher than the second resistance threshold R_{TH_LRS}, for example equal to 10*R_{TH_LRS}.

This figure shows that the second set technique "Verify Set V_{TE}" is the fastest method to correct the hard fails (for this reference array, almost all hard fails are corrected after ten programming cycles). The second set technique "Verify Set V_{TE}" is then an effective method for setting memory cells that have been deeply reset (memory cells that have a wide conductive filament).

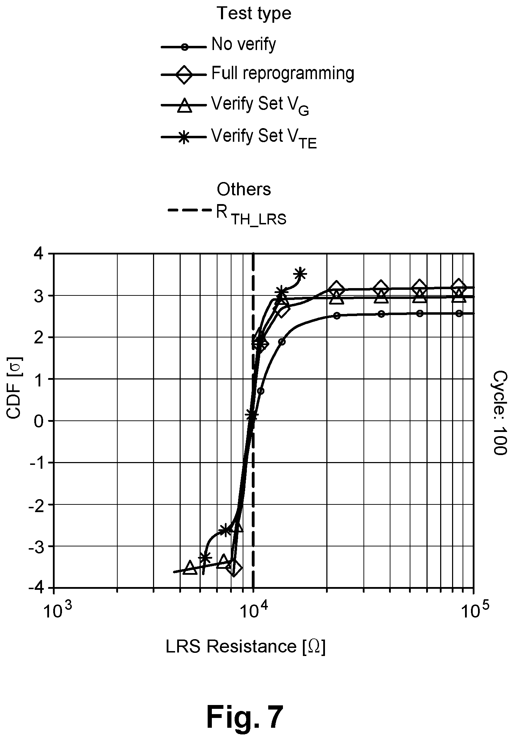

Figure 7 show the effects of the different set techniques on the distribution of the LRS resistance values, after 100 programming cycles of the reference array. This figure shows that the third set technique "Verify Set V_{G}" has a more pronounced effect of shifting the resistance distribution towards to low resistance values. Thanks to this technique, a significant amount of memory cells having a resistance slightly higher than the second resistance threshold R_{TH_LRS}, here equal to 10⁴ Ω, are corrected (at the 100^{th} programming cycles). It can be also seen the effect of the second set technique "Verify Set V_{TE}" on the high resistance tail of the LRS resistance distribution.

The programming method according to the invention optimally combine several set techniques having different effect on the behavior of the memory cells (in particular on the formation of the conductive filament) to improve the LRS resistance distribution and improve the bit error ratio of the array.

The plurality of set techniques may comprise other set techniques than those described above, for example applying pulses with increasing duration to the top electrode of the resistive memory element. The second and third set techniques (Verify Set V_{TE} and Verify Set V_{G}) may comprise another sequence of the set, reset and R&V operations. For example, a R&V operation may also follow each reset operation.

Another aspect of the invention relates to an electronic circuit comprising an array of resistive memory cells (OxRAM, CBRAM, PCRAM, FeRAM) and means for implementing the programming method of figure 2.

In an embodiment, the electronic circuit comprises:
- a power source configured to generate voltage pulses;
- an addressing circuit configured to apply the voltage pulses to the top electrode 12b of the memory resistive element, to the source of the selection transistor 20 and to the gate of the selection transistor 20;
- a non-volatile memory storing bit error ratio (BER) values corresponding to the different set techniques; and
- a controller configured (or programed) to retrieve from the memory the BER values corresponding to the different set techniques, to compare the bit error ratio values at each programming cycle, to determine the set techniques having the lowest BER and to send control signals to the power source so that it generates the voltage pulses corresponding to the set techniques having the lowest BER.

The sequence of the set techniques may be stored in a non-volatile memory.

The power source may comprise one or more voltage generators, preferably at least one variable voltage generator capable of generating pulses of increasing amplitude.

The addressing circuit may comprise multiplexers, bit lines (connected to top electrodes 12b of the resistive memory elements 10 of the array), word lines (connected to the gate of the selection transistors 20 of the array) and, in an embodiment, source lines (connected to the source of the selection transistors 20).

The non-volatile memory is for example a read-only memory (ROM) or a Flash memory. It may be internal or external to the controller.

The scope of protection of the present invention is definhed by appended claims 1-6.

## Claims

1. Method for programming at least one resistive memory cell of an array of resistive memory cells, said method comprising a sequence of N programming cycles (Cⱼ), N being an integer greater than or equal to 2, each programming cycle comprising a set step (SETⱼ) and a reset step (RST), each set step comprising the application of a set technique chosen among a plurality of set techniques, wherein each resistive memory cell comprises a resistive memory element and a selection transistor connected in series with the resistive memory element and wherein the plurality of set techniques comprises:
- full reprogramming: said full reprogramming comprising applying at least on reprogramming cycles, each reprogramming cycle comprising a reset operation followed by a set operation followed by a read and verify operation; and
- verify Set V_{TE}: said verify Set V_{TE} comprises applying voltage pulses with increasing positive amplitudes on a top electrode of the resistive memory element; and
- verify Set V_{G}: said verify Set V_{G} comprises applying voltage pulses with increasing positive amplitudes on a gate of the selection transistor;
said method comprising the following steps:
- acquiring a bit error ratio (BER) value corresponding to each programming cycle for each set technique of said plurality of set techniques;
- at each programming cycle, applying the set technique having the lowest bit error ratio (BER) value corresponding to said programming cycle.

2. Method according to the previous claim, wherein the plurality of set techniques are algorithms comprising set operations and reset operations and read and verify operations.

3. The method according to any one of the previous claims, wherein the bit error ratio (BER) value corresponding to each programming cycle for each set technique is measured prior to the programming cycles (Cⱼ) by characterizing a reference array of resistive memory cells and a sequence of the set techniques to be applied during the programming cycles (Cⱼ) is then defined.

4. The method according to any one of the previous claims, wherein the bit error ratio (BER) value corresponding to each programming cycle for each set technique is acquired from a database.

5. The method according to the previous claim, wherein the bit error ratio (BER) value corresponding to each programming cycle for each set technique is measured prior to the programming cycles (Cⱼ) by characterizing a reference array of resistive memory cells and then stored in the database.

6. Electronic circuit comprising an array of resistive memory cells and means for implementing the programming method according to any of the previous claims, wherein each resistive memory cell comprises a resistive memory element and a selection transistor connected in series with the resistive memory element, said means comprising:
- a power source configured to generate voltage pulses;
- an addressing circuit configured to apply the voltage pulses:
- to the top electrode of at least a memory resistive element of the array of resistive memory cells; and
- to the gate of the selection transistor;
- a non-volatile memory storing bit error ratio (BER) values corresponding to the different set techniques; and
- a controller configured to retrieve from the non-volatile memory the BER values corresponding to the different set techniques, to compare the bit error ratio values at each programming cycle, to determine the set technique having the lowest BER and to send control signals to the power source so that it generates the voltage pulses corresponding to the set techniques having the lowest BER.

## Patentansprüche

1. Verfahren zum Programmieren mindestens einer resistiven Speicherzelle eines Netzwerks aus resistiven Speicherzellen, wobei das Verfahren eine Abfolge von N Programmierzyklen (Cⱼ) umfasst, wobei N eine ganze Zahl größer oder gleich 2 ist und jeder Programmierzyklus einen Initialisierungsschritt (SETⱼ ) und einen Rücksetzschritt (RST) umfasst, wobei jeder Initialisierungsschritt die Anwendung einer Initialisierungstechnik umfasst, die aus einer Vielzahl von Initialisierungstechniken ausgewählt wird, wobei jede resistive Speicherzelle ein resistives Speicherelement und einen mit dem resistiven Speicherelement in Reihe geschalteten Auswahltransistor umfasst, und wobei die Vielzahl von Initialisierungstechniken umfasst:
- die vollständige Neuprogrammierung: wobei die vollständige Neuprogrammierung die Durchführung von mindestens mehreren Neuprogrammierungszyklen umfasst, wobei jeder Neuprogrammierungszyklus einen Rücksetzvorgang, gefolgt von einem Initialisierungsvorgang und anschließend einem Lese- und Überprüfungsvorgang umfasst; und
- die Initialisierungsprüfung V_{TE}: Die Initialisierungsprüfung V_{TE} umfasst das Anlegen von Spannungsimpulsen mit ansteigenden positiven Amplituden an eine obere Elektrode des resistiven Speicherelements; und
- die Initialisierungsprüfung V_{G}: Die Initialisierungsprüfung V_{G} umfasst das Anlegen von Spannungsimpulsen mit ansteigenden positiven Amplituden an ein Gate des Auswahltransistors;
wobei das Verfahren die folgenden Schritte umfasst:
- Erfassen eines Bitfehlerratenwerts (BER), der jedem Programmierzyklus für jede Initialisierungstechnik aus der Vielzahl von Initialisierungstechniken entspricht;
- bei jedem Programmierzyklus das Anwenden der Initialisierungstechnik, die den niedrigsten Bitfehlerratenwert (BER) aufweist, der dem jeweiligen Programmierzyklus entspricht.

2. Verfahren nach dem vorstehenden Anspruch, bei dem die Vielzahl an Initialisierungstechniken Algorithmen sind, die Initialisierungs- und Rücksetzvorgänge sowie Lese- und Überprüfungsvorgänge umfassen.

3. Verfahren nach einem der vorstehenden Ansprüche, bei dem der jedem Programmierzyklus entsprechende Wert der Bitfehlerrate (BER) für jede Initialisierungstechnik vor den Programmierzyklen (Cⱼ) durch Charakterisierung einer Referenzanordnung aus resistiven Speicherzellen gemessen wird und eine Abfolge der während der Programmierzyklen (Cⱼ) anzuwendenden Initialisierungstechniken festgelegt wird.

4. Verfahren nach einem der vorstehenden Ansprüche, bei dem der jedem Programmierzyklus für jede Initialisierungstechnik entsprechende Wert der Bitfehlerrate (BER) aus einer Datenbank abgerufen wird.

5. Verfahren nach dem vorstehenden Anspruch, bei dem der jedem Programmierzyklus für jede Initialisierungstechnik entsprechende Wert der Bitfehlerrate (BER) vor den Programmierzyklen (Cⱼ) durch Charakterisierung einer Referenzanordnung aus resistiven Speicherzellen gemessen und anschließend in der Datenbank gespeichert wird.

6. Elektronische Schaltung, die eine Anordnung aus resistiven Speicherzellen und Mittel zur Durchführung des Programmierverfahrens nach einem der vorstehenden Ansprüche umfasst, wobei jede resistive Speicherzelle ein resistives Speicherelement und einen mit dem resistiven Speicherelement in Reihe geschalteten Auswahltransistor umfasst, wobei die Mittel Folgendes umfassen:
- eine Stromquelle, die so ausgelegt ist, dass sie Spannungsimpulse erzeugt;
- eine Adressierungsschaltung, die so ausgelegt ist, dass sie die Spannungsimpulse anlegt:
- an die obere Elektrode mindestens eines resistiven Speicherelements des Netzwerks aus resistiven Speicherzellen; und
- an das Gate des Auswahltransistors;
- einen nichtflüchtigen Speicher, der Werte der Bitfehlerrate (BER) speichert, die den verschiedenen Initialisierungstechniken entsprechen; und
- eine Steuerung, die so ausgelegt ist, dass sie die den verschiedenen Initialisierungstechniken entsprechenden BER-Werte aus dem nichtflüchtigen Speicher abruft, um die Bitfehlerratenwerte bei jedem Programmierzyklus zu vergleichen, um die Initialisierungstechnik mit der niedrigsten BER zu ermitteln und um Steuersignale an die Stromquelle zu senden, damit diese die Spannungsimpulse erzeugt, die den Initialisierungstechniken mit der niedrigsten BER entsprechen.

## Revendications

1. Procédé de programmation d'au moins une cellule de mémoire résistive d'un réseau de cellules mémoire résistive, ledit procédé comprenant une séquence de N cycles de programmation (Cⱼ), N étant un nombre entier supérieur ou égal à 2, chaque cycle de programmation comprenant une étape d'initialisation (SETⱼ) et une étape de réinitialisation (RST), chaque étape d'initialisation comprenant l'application d'une technique d'initialisation choisie parmi une pluralité de techniques d'initialisation, dans lequel chaque cellule de mémoire résistive comprend un élément de mémoire résistive et un transistor de sélection connecté en série avec l'élément de mémoire résistive, et dans lequel la pluralité de techniques d'initialisation comprend :
- la reprogrammation complète : ladite reprogrammation complète comprenant l'application au moins sur des cycles de reprogrammation, chaque cycle de reprogrammation comprenant une opération de réinitialisation suivie d'une opération d'initialisation suivie d'une opération de lecture et de vérification ; et
- la vérification d'initialisation V_{TE} : ladite vérification d'initialisation V_{TE} comprend l'application d'impulsions de tension avec des amplitudes positives croissantes sur une électrode supérieure de l'élément de mémoire résistive ; et
- la vérification d'initialisation V_{G} : ladite vérification d'initialisation V_{G} comprend l'application d'impulsions de tension avec des amplitudes positives croissantes sur une grille du transistor de sélection ;
ledit procédé comprenant les étapes suivantes :
- l'acquisition d'une valeur de taux d'erreur sur les bits (BER) correspondant à chaque cycle de programmation pour chaque technique d'initialisation de ladite pluralité de techniques d'initialisation ;
- à chaque cycle de programmation, l'application de la technique d'initialisation présentant la valeur de taux d'erreur sur les bits (BER) la plus faible correspondant audit cycle de programmation.

2. Procédé selon la revendication précédente, dans lequel la pluralité de techniques d'initialisation sont des algorithmes comprenant des opérations d'initialisation et des opérations de réinitialisation, et des opérations de lecture et de vérification.

3. Procédé selon l'une quelconque des revendications précédentes, dans lequel la valeur de taux d'erreur sur les bits (BER) correspondant à chaque cycle de programmation pour chaque technique d'initialisation est mesurée avant les cycles de programmation (Cⱼ) en caractérisant un réseau de référence de cellules de mémoire résistive, et une séquence des techniques d'initialisation à appliquer pendant les cycles de programmation (Cⱼ) est définie.

4. Procédé selon l'une quelconque des revendications précédentes, dans lequel la valeur de taux d'erreur sur les bits (BER) correspondant à chaque cycle de programmation pour chaque technique d'initialisation est acquise à partir d'une base de données.

5. Procédé selon la revendication précédente, dans lequel la valeur de taux d'erreur sur les bits (BER) correspondant à chaque cycle de programmation pour chaque technique d'initialisation est mesurée avant les cycles de programmation (Cⱼ) en caractérisant un réseau de référence de cellules de mémoire résistive, puis stockée dans la base de données.

6. Circuit électronique comprenant un réseau de cellules de mémoire résistive et des moyens pour implémenter le procédé de programmation selon l'une quelconque des revendications précédentes, dans lequel chaque cellule de mémoire résistive comprend un élément de mémoire résistive et un transistor de sélection connecté en série avec l'élément de mémoire résistive, lesdits moyens comprenant :
- une source d'alimentation configurée pour générer des impulsions de tension ;
- un circuit d'adressage configuré pour appliquer les impulsions de tension :
- à l'électrode supérieure d'au moins un élément de mémoire résistive du réseau de cellules de mémoire résistive ; et
- à la grille du transistor de sélection ;
- une mémoire non volatile stockant des valeurs de taux d'erreur sur les bits (BER) correspondant aux différentes techniques d'initialisation ; et
- un contrôleur configuré pour extraire de la mémoire non volatile les valeurs de BER correspondant aux différentes techniques d'initialisation, pour comparer les valeurs de taux d'erreur sur les bits à chaque cycle de programmation, pour déterminer la technique d'initialisation présentant le BER le plus faible et pour envoyer des signaux de contrôle à la source d'alimentation afin qu'elle génère les impulsions de tension correspondant aux techniques d'initialisation présentant le BER le plus faible.
